# EUROPEAN PATENT SPECIFICATION

(11) **EP 2 050 311 B1**
(45) Date of publication and mention of the grant of the patent: **27.02.2019**
(21) Application number: 07802524.4
(22) Date of filing: 07.08.2007
(51) Int. Cl.: H05B 6/02

(54) **APPARATUS FOR POROUS MATERIAL DENSIFICATION**
VORRICHTUNG ZUR DENSIFIZIERUNG VON PORÖSEN MATERIALEN
APPAREIL POUR DENSIFICATION DE MATÉRIAUX POREUX

(30) Priority: 07.08.2006 US 821596 P
(43) Date of publication of application: 22.04.2009
(73) Proprietor: Safran Landing Systems, 78140 Vélizy-Villacoublay (FR)
(72) Inventor: CHANG, Kenny, Union, KY 41091 (US); ZIMMERMAN, Bruce, Union ,KY 41091 (US); FILLION, Arnaud, Independence, KY 41051 (US)
(74) Representative: Delumeau, François Guy
(86) International application number: PCT/EP2007/058195
(87) International publication number: WO 2008/017677

(56) References cited:
- FR-A- 2 760 741
- US-A- 3 755 644
- US-A- 4 770 355
- US-A1- 2004 253 377

## Description

### Prior applications:

This application claims the benefit of priority from U.S. Provisional Application No. 60/821,596 filed on August 7, 2007, the entire content of which is incorporated by reference herein.

### Field of the invention:

The present invention relates to densifying porous articles with a desirably high rate of production, particularly, but not necessarily only, with respect to the field of friction braking articles, such as aircraft brakes.

### Background of the invention:

In the field of friction materials, it is generally known to use porous material substrates to manufacture friction members, such as friction brake disks.

The manufacture of such friction members generally begins with the construction of a porous preform. For example, in many friction brake applications, annular preforms are used. The annular preforms can be constructed using several different known methods. For example, carbon fiber fabric plies can be needled together and annular preforms can be cut from the stacked material. Oxidized polyacrylonitride ("PAN") fibers or pitch-based fibers are common examples of starting fibers used in this type of application. Subsequently, these fibers may be carbonized in a high temperature treatment step prior densification.

Thereafter, the porous preforms are densified. A generally known method of densification uses a liquid precursor of a material that deposited within the porous preform to densify the preform. This kind of densification is sometimes referred to in the art as "film boiling."

In general, film boiling densification involves immersing a porous preform in a liquid hydrocarbon so that the liquid substantially completely infiltrates the pores and interstices of the preform. Thereafter, the immersed preform is inductively heated to a temperature above the decomposition temperature of liquid hydrocarbon (typically 1000°C or more, typically up to about 1400°C). More particularly, the liquid hydrocarbon adjacent to the inductively heated preform structure dissociates into various gas phase species within the preform porosity. Further thermal decomposition of the gas phase species results in the formation of pyrolitic carbon on interior surfaces in the open regions of the porous material.

FR 2 760 741 discloses a method of densifying a porous article in which a porous structure is placed in a susceptor, and the two are placed within a tubular induction heating device.

US 2004/0253377 discloses a CVI densification furnace in which objects to be densified are passed in batch between horizontally parallel heater plates which can be induction heaters.

The use of liquid precursors for densification is discussed in, for example, US Patent Nos. 4 472 454, 5 389 152, 5 397 595, 5 733 611, 5 547 717, 5 981 002, and 6 726 962.

### Brief Description of the Drawings:

The present invention will be even more clearly understandable with reference to the drawings appended hereto, in which:
Figure 1 is a cutaway schematic side view of a liquid densification apparatus;
Figure 2 is a cutaway schematic top view of a liquid densification apparatus generally corresponding to that seen in Figure 1;
Figure 3 is a schematic cross sectional view of a porous article mounted relative to conventional induction coils for inductively heating the article;
Figure 4 is a schematic cross sectional view of a porous article mounted relative to induction coils according to the present invention, for inductively heating the article;
Figure 5 is a close-up cross sectional view of a part of an induction coil as illustrated in Figure 4;
Figure 6 is an enlarged partial view of the arrangement illustrated in Figure 4;
Figure 7 is a schematic side view illustrating an arrangement for mounting a porous article in the apparatus of the present invention;
Figure 8 is a schematic perspective view of an exemplary apparatus for liquid densification of multiple porous articles;
Figure 9 is a schematic cross sectional view of an exemplary apparatus for liquid densification of multiple porous articles; and
Figures 10-12 are X-ray images of a densified porous preform for illustrating an effect that the structure of the inductive heating coils has on densification.

### Detailed description of the invention:

A typical densification facility according to the present invention includes one or more reactor chambers generally sized and constructed to hold one or more preform members therein, with corresponding induction heating coils, while substantially immersed in the liquid precursor of choice. For example, the reactor chambers could be suitably manufactured from aluminum. Other suitable materials are non-magnetic and include, without limitation, glass, stainless steel, ceramic or combinations thereof. Dedicated inner buses and coils are provided depending on the size of the preforms being densified. Typical examples of preform diameters range from about 10" to about 25" and the thickness ranges from 15 mm to 50 mm. Particularly common examples include 15" and 20" diameter preforms.

The one or more reaction chambers are each provided with induction heating coils corresponding to each preform that is to be processed. The induction coils and the preforms being processed are preferably mounted in position relative to each other using chemically non-reactive and thermally stable support frames made from, for example, an electrically non-conductive glass composite material that can withstand a liquid hydrocarbon environment (such as that known in the art as "G-10").

The induction heating coils are preferably water-cooled pancake spiral coils, and are commonly made from copper metal. For this reason, it is desirable to provide a heat exchanger dedicated to the water-cooling system for the induction coils, as will be discussed in further detail below. In use, a preform (or worn brake) being densified is heated by direct coupling from the induction coil.

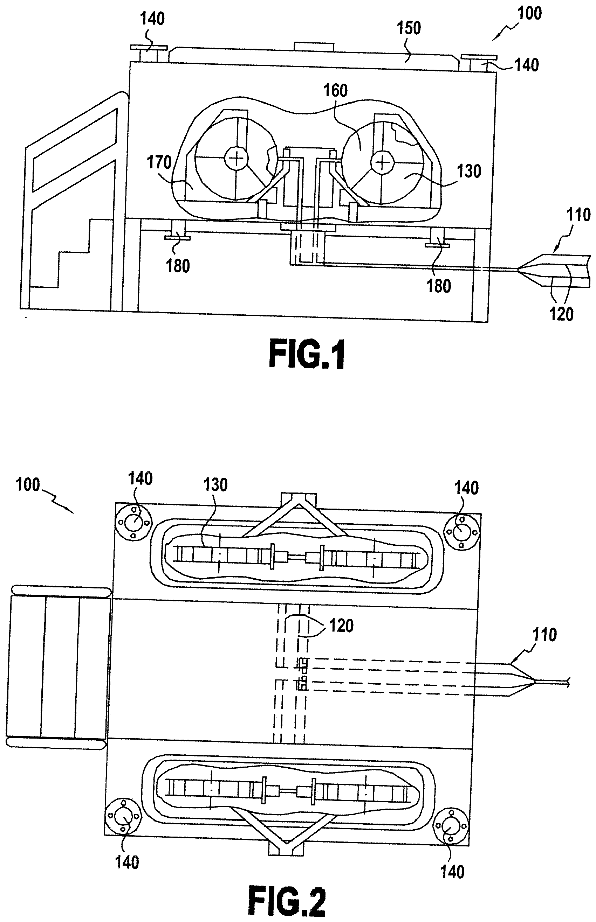

Figure 1 and 2 are side and top schematic view of a coil/reactor chamber 100 generally in accordance with the present invention. Loading and unloading of one or more preforms 160 require, for example, a locking mechanism is provided for the selectably openable top lid 150.

Each reactor chamber 100 (as many as are provided) is connected with a common precursor supply line 180 and a common exhaust line 140 to the condenser and thermal oxidizer. Each reactor chamber 100 can be filled, drained, and monitored from the computer control system. The exhaust vapor from the densification process is condensed and fed back to the reactors, whereas the residual effluent gas is preferably then taken to a conventional thermal oxidizer (not shown) and burned.

For the preform to reach its full density, it is desirable that the center of the preform initially be heated above the pyrolysis temperature of the precursor liquid. As densification proceeds, the densification moves radially outwards from the center portions of the preform because of the heating profile created by induction heating. In one example, the frequency of the power supply is set (in view of the material characteristics of the preform) to provide a skin depth roughly near the center of the preform. As the center of the preform densifies, the frequency of the power supply increases in response to changes in the electrical characteristics of the preform caused by densification.

Certain features of the presently contemplated invention are now discussed hereinbelow, and are distinguished where appropriate from conventional aspects of film boiling densification.

In one contemplated example, the induction coils in a respective reaction chamber are associated with a corresponding power supply. An example of a commercially-available power supply suitable for this application is a Model No. LSP 14-400/30 Lepel induction-type power supply.

The power from the power supply is transferred to the induction coils by custom-built (depending on the physical arrangements of a given densification facility) copper bus bars with external water cooling networks.

The Lepel power supply, for example, has remote PID loop control capability and can be monitored and controlled from a computer control terminal. Power density, voltage control, current control, frequency control, and/or temperature control of the densification process by known methods is also within the scope of the contemplated arrangement.

An appropriate liquid precursor is supplied to the reaction chamber(s) from a precursor storage tank. The system includes a conventional fluid transfer system for managing the transport of new (and used) precursor liquid (not shown). The fuel transfer system may include one or more remote storage tanks for storing a new liquid precursor supply as well as possibly temporarily storing used precursor liquid. A relatively smaller local storage tank for new precursor liquid can also be provided.

One example of a precursor liquid used according to the present system is cyclohexane (C₆H₁₂). However, depending on the selection of the precursor liquid, the corresponding deposited material could be any of, strictly by way of example and without limitation, carbon, silicon carbide, silicon nitride, carbon-silicon carbide, or carbon-silicon nitride. To deposit carbon within the preform, for example, a hydrocarbon such as cyclohexane, n-hexane, benzene, toluene, or combinations thereof can be used. Methyltrichlorosilane, dimethyldichlorosilane, and methydichlorosilane, tris-n-methyl amino silane, or other organosilane mixtures can be used for depositing silicon carbide and silicon nitride.

Moreover, the precursor liquid can be chosen to co-deposit materials. For example, a mixture of silicon carbide and silicon nitride can be deposited using tris-n-methyl amino or other silane compound. Also, co-deposited materials such as carbon-silicon carbide and carbon-silicon nitride can be produced with an appropriately selected mixture of precursors. Depending upon the desired matrix, silicon carbide or silicon nitride interface coating can be produced during an early stage of the densification or co-deposited throughout the matrix densification.

Preferably, sufficient liquid precursor is provided to substantially immerse the preform being densified, as well as the induction heating coils associated therewith. As mentioned before, the film boiling process creates gaseous species that eventually cause the formation of pyrolitic carbon on interior surfaces of the preform porosity. Precursor vapor is preferably captured to the extent possible and condensed for possible recycling in the process. Effluent gas that is still left over is preferably conveyed to a thermal oxidizer of a known configuration to burn off residual hydrocarbons in the effluent gas.

The structure of the induction coils 130 used in film boiling densification processes is very important for obtaining densified preforms having suitable mechanical characteristics, including friction characteristics.

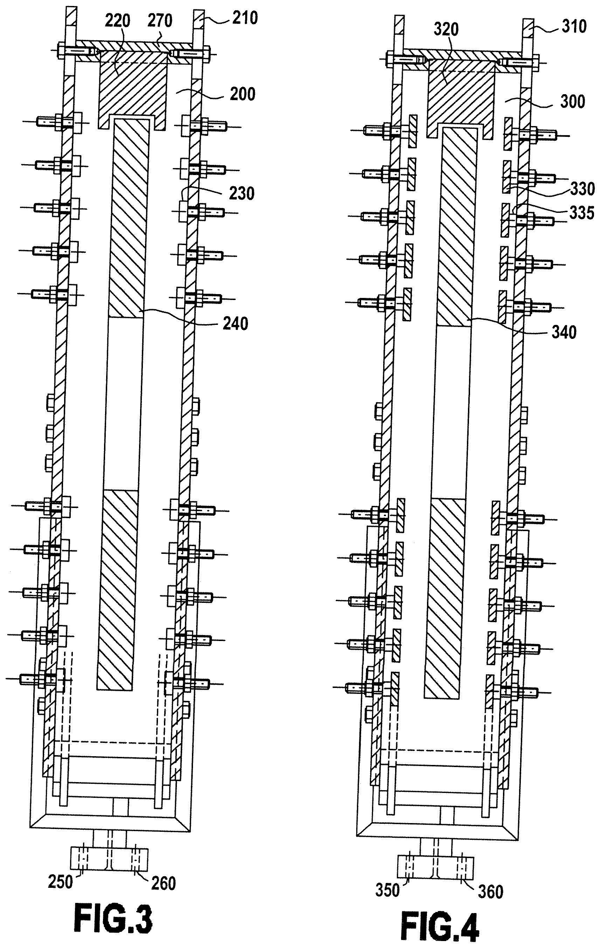

Using conventional pancake coils constructed from hollow copper tubing (square or round), as illustrated in Figure 3 for example, can result in undesirable "spiral" densification (sometimes referred to as a "mirror effect") corresponding to the constructions of spiral induction coil. It has been determined that conventional copper tubing is relatively difficult to form (i.e., bend) into a pancake coil, particularly with respect to maintaining a consistent gap between adjacent turns of the coil. In turn, the desire to maintain a consistent (and relatively small) gap between coil turns causes manufacturing and structural issues with respect to suitably bending the copper tubing to provide the tight turns necessary.

A particular difference between the convention inductive coil of Figure 3 and that of Figure 4 is the fact that the prior induction heating coil 200 shown in Figure 3 is made from square or round hollow copper tubing 230 bent into the desired coil form. The copper tubing functions both to transmit the power for inductive heating (through the copper metal) and convey cooling water through the inlet port 250 and the outlet port 260. The coil 200 of Figure 3 has, for example, a nominal ¾" gap with an inner diameter (ID) coverage of 18" and an outer diameter (OD) coverage of 8.5". For the purpose of illustration, Figure 3 shows a carbonized preform 240 placed inside of an alumina holder 220 and supported with a G-10 holder 270.

In contrast, Figure 4 shows an example of an induction heating coil 300 according to the present invention is fabricated from, for example, ¼" solid copper plate that is milled or otherwise machined into the desired coil form 330, instead of being turned or bent into shape as the coil in Figure 3 is. Preferably, a high precision machining operation is used to form the coil from the copper plate, such as, for example, CNC milling and the like. A hollow metal (copper, for example) water cooling tube 335 is brazed on an exterior (i.e., opposite the side facing the preform in use) side of the machined copper coil 330. The braze composition may be any commercially available composition suitable for brazing copper as long as it can withstand the expected temperature environment.

Because the currently contemplated induction coil uses a machined flat copper plate, it can be produced with greater precision (particularly with respect to gaps between turns of the coil) than bending copper tubing. In addition, the machined copper plate does not undergo stress and strain deformation like bent copper tubing.

A gap between adjacent turns of the coil according to the invention is substantially consistent, and is between about 4mm to about 8mm. Each coil has an outside diameter of about 25 inches and an inside diameter of about 3 inches.

In addition, it has been observed that in some cases, the conventional copper tube becomes distended and at least susceptible to rupture (in a manner not unlike a vascular aneurysm) (if rupture does not in fact occur). It is tentatively believed that the conventional copper tube induction coil can become too hot for the cooling water to adequately dissipate the heat. It is speculated that this can cause vaporization of the cooling water within the conventional copper tubing with an unacceptable pressure increase therein. This pressure is believed to result in the bulging tubing deformation and an elevated risk of tube rupture.

The possibility that the copper tubing could rupture during a densification process cannot be neglected, bearing in mind that the coil is immersed in a liquid hydrocarbon precursor during densification. If cooling water were to escape the coil during densification (for example, because of a tubing failure), the water would flash to steam, which would provide an oxygen source. Because the liquid hydrocarbon is typically already above its self-combustion temperature during densification, the introduction of an oxygen source would present a grave risk of explosion.

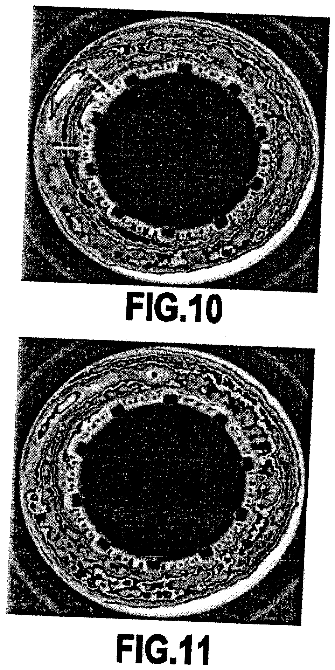

Also, a prior induction coil made from copper tubing (such as that illustrated in Figure 3) suffers from a spiral densification characteristic and weak densification at the radially inner and outer peripheries, as can be seen below in Figures 10 and 11.

"Spiral densification" is an art-recognized term which generally refers to non-homogenous densification, particularly characterized by generally circumferential "streaks" - regions in which the densification is non-trivially different from adjacent regions. This problem is significantly related to imperfections in coil design, especially with respect to the gap distance between adjacent turns of the coil. It will be appreciated that if the coil structure is not carefully monitored, gaps between coil turns may occur that lead to insufficient heating of the adjacent preform. This results in turn in poor densification. In addition, pancake coil distance is usually in a fixed position which does not allow for any adjustment for the depth penetration.

The preforms illustrated in Figures 10 and 11 were formed with a conventional copper tubing induction coil in a film boiling densification process. In both images, large, circumferentially extending regions of density variation are evident. In particular, a region of very low density (corresponding to the white region at approximately the "10 o'clock" position of both preforms is noticeable. In addition, as mentioned above, poor densification can be seen, for example, at the radially outward periphery of the preforms. See, for example, the white region along approximately the bottom halves of each X-ray scan.

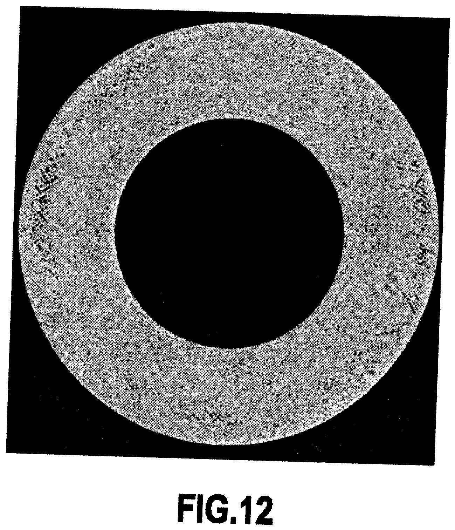

Figure 12 is a similar type of X-ray scan which illustrates the densification of a preform densified using an induction coil made from a machined copper plate and having a cooling water tube brazed thereto, as described above with reference to Figure 4. The important feature to note between Figures 10 and 11 relative to Figure 12 is the absence of distinct or prominent circumferentially extending blotches and the like in Figure 12 (unlike in Figures 10 and 11), which indicate large variations in densification levels, and more particularly, regions of undesirably low densification.

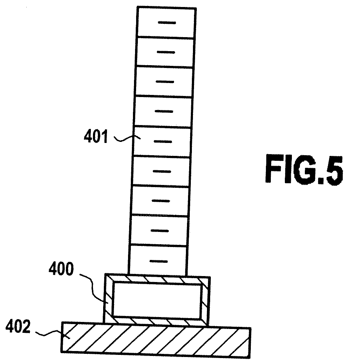

Figure 5 hereinbelow is a cross-sectional view of one segment of an induction coil according to the present invention. A cooling water tube 400 brazed to an exterior (with respect to a preform being densified) side of the machined copper coil 402 used as the induction heating coil. A mounting fixture, such as a bolt shaft 401 may be attached to an exterior of the cooling water tube 400 for mounting the coil to a support within the reaction chamber.

As discussed above, the reaction chamber according to the present invention includes at least one induction heating coil as described herein, for inductively heating a preform mounted adjacent thereto. In a typical arrangement, pairs of coils are provided and a preform being treating is mounted between them.

It is known in the art that preforms are generally soft and pliable before being densified. Therefore, it is desirable to hold a preform relative to the inductive heating coil in such a manner so as to reduce bending and other forms of warping or deformation before the preform is densified.

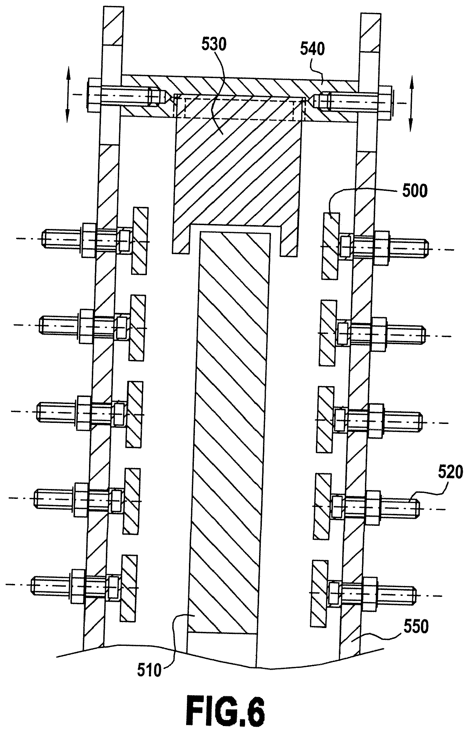

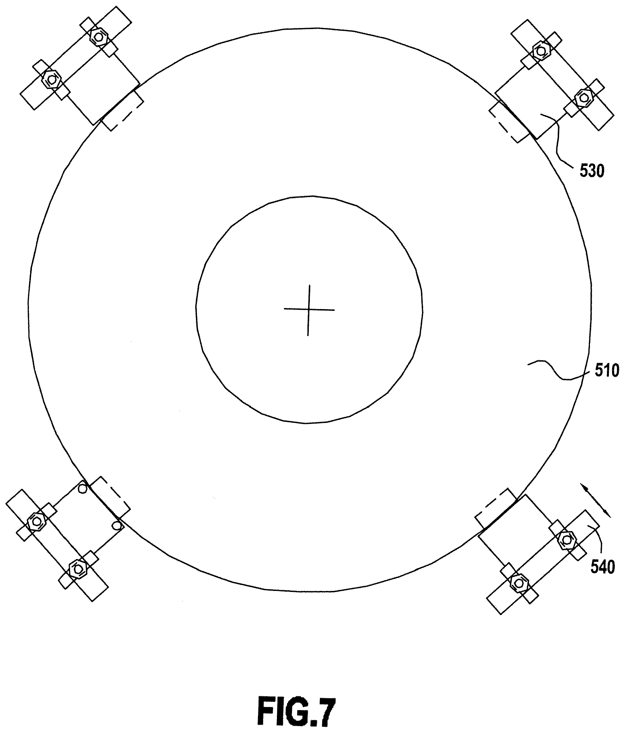

In one arrangement, support members may be used to hold the preform in place. See, for example, Figures 6 and 7. In the above-illustrated example, the preform is held in place by one or more supports 530 mounted, for example, on the same supports on which the induction coils are mounted. The supports may be, for example, non-reactive quartz glass or alumina cylinders having an appropriately sized and aligned notch formed therein. As indicated by the bidirectional radially extending arrows in Figures 6 and 7, the radial (with respect to the preform) position of some or all of the supports can be adjusted to, for example, accommodate insertion of the preform relative to the heating coils, or to accommodate preforms of different diameters.

The distance between coils and the preform can be adjusted by screwing in or out of the bolt shaft 520 (corresponding to the bolt shaft 401 seen in Figure 5) in order to provide effective heating during initial densification. Control of this spacing between the induction coils and the preform can help control current concentrations in the preform during inductive heating, so as to avoid "mirror effect" or "spiral" densification on the one hand, and to increase power yield by not spacing the coil too far away from the preform.

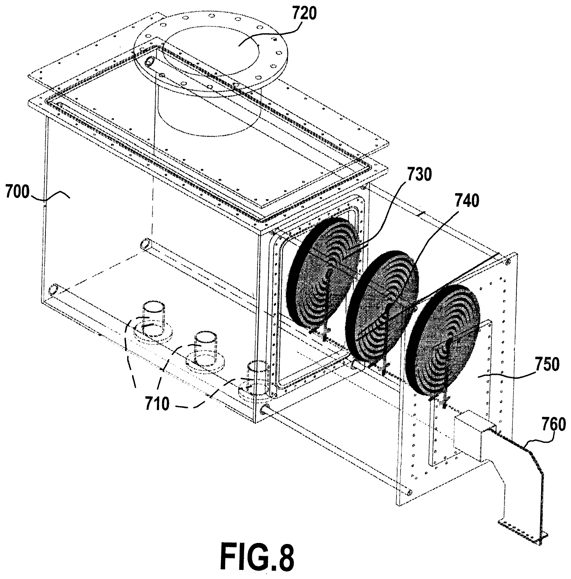

Figure 8 hereinbelow is a perspective view of a reaction chamber 700 according to the present invention into which three preforms (and associated induction heating coils) are loaded. This illustration is strictly by way of example to illustrate the densification of multiple porous parts, and other loading arrangements with other numbers of preforms are possible.

Overall, the multiple-part densification shows another way of producing carbon disks in at least a three-part densification configuration. In this arrangement, the liquid precursor is supplied to the reaction chamber 700 through ports 710. The power from the power supply is transferred to the induction coils 730 by appropriately arranged (depending on the physical arrangements of a given densification facility) copper bus bars 760 with external water cooling networks.

As previously mentioned, the porous parts are secured and positioned in the center of the pancake coils 730 during densification. The Lepel power supply, for example, has remote PID loop control capability and can be monitored and controlled from a computer control terminal. Power density, voltage control, current control, and/or temperature control of the densification process by known methods is also within the scope of the contemplated arrangement.

The liquid precursor is supplied to the reaction chamber(s) 700 from the local precursor storage tank. Preferably, sufficient liquid precursor is provided to substantially immerse the preform(s) being densified, as well as the induction heating coils associated therewith. The film boiling process creates gaseous species that in part causes the formation of pyrolitic carbon on interior surfaces of the preform porosity. Precursor vapor is released thru an exhaust line 720 and vented to an external condenser (not shown) for possible recycling in the process. Effluent gas that is still left over is preferably conveyed to a thermal oxidizer (not shown).

In this example of a coil/reactor chamber 700, loading and unloading of the porous preforms require, for example, bolting and unbolting a front reactor cover panel 750 and corresponding external bus connection 760. Each reactor chamber 700 (as many as are provided) is connected with a common precursor supply line and a common exhaust line 720 to the condenser and thermal oxidizer. Each reactor chamber can be filled, drained, and monitored from the computer control system. The exhaust vapor from the densification process is condensed and fed back to the reactors, whereas the residual effluent gas is then taken to the thermal oxidizer and burned.

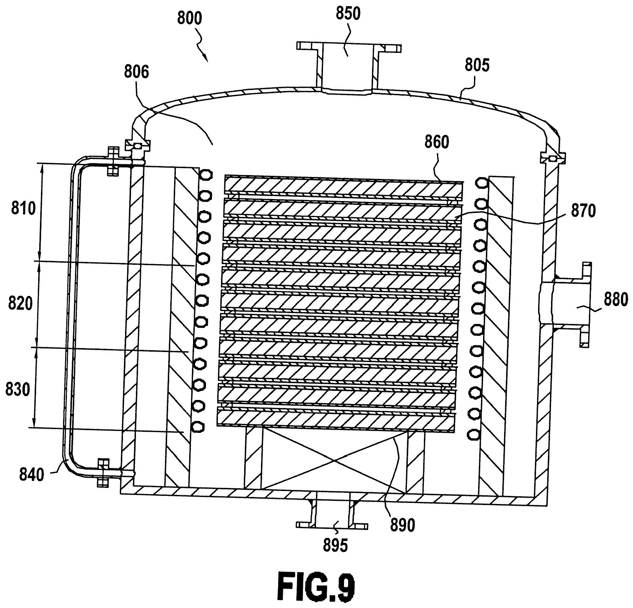

Figure 9 illustrates another arrangement for the liquid densification of multiple porous parts. This illustration shows the densification of multiple porous parts 870 inside of a sealed reaction chamber 800. A load stack consisting of multiple porous parts 870 and graphite plates 860 therebetween are pre-assembled. The load stack is placed on a ceramic or electrically insulated stand 890 and the furnace lid 805 is removed during the loading and unloading operation. The power from the power supply is transferred to the multi-zone coil 810, 820, and 830 through power port 880. Individual PID zone control is made possible through power density, voltage control, current control, frequency control, and/or temperature control for the densification process.

The heating of the porous parts 870 is accomplished by using, for example, a multi-zone induction coil 810, 820, 830 which is directly coupled to the graphite plates 860. The annular graphite plates 860 have similar ID and OD dimensions as the annular porous parts and the thickness of the annular graphite plate ranges between 5 mm to 25 mm.

In this case the densification fronts start from the heated preform surfaces which are in contact with the graphite plates 860. Liquid precursor is supplied to the reactor chamber 800 and the liquid can be filled and drained through port 895. A liquid level indicator 840 indicates the level of precursor fluid during the fill, drain, and densification. Sufficient liquid precursor is provided to substantially immerse the load stack inside of the reactor chamber cavity 806. A continuous feed of liquid precursor is also possible during the densification process.

As mentioned previously, the densification process creates gaseous species and the vapor is released from port 850 and directed to the condenser for possible recycling purpose. Effluent gas that is not captured is conveyed to the thermal oxidizer to bum off the residual hydrocarbons.

It is thought that it might be useful to mount a preform with respect to corresponding coils such that the preform could be rotated about its center during densification, under influence of the heating coils. For example, a mounting assembly could be provided at the center of a given preform that could be appropriately connected to a driving device located outside of the respective reaction chamber. The rate of rotation of the preform might be from about one to about five revolutions per minute, as currently contemplated.

It can be useful according to the contemplated system to provide the coils and/or the buses with a non-stick.electrically-insuiating coatingrsuch as epoxy or polytetrafluoroethylene to prevent electrical load faults or shorting caused by inadvertent contact between the preform and the coil and/or bus.

While the present invention has been described with respect to what are believed to be the most practical embodiments thereof, it is particularly noted that this is by way of example only. The present invention is defined solely by the claims appended hereto.

## Claims

1. An inductive heating assembly comprising:
a support frame (170, 210, 310);
at least one pair of spiral induction heating coils (300) mounted on the support frame and being aligned with one another in a generally parallel orientation, the pair of induction heating coils being spaced apart from each other by a coil separation distance; and
an electrical power supply electrically connected to the pair of induction heating coils;
**characterized in that** each spiral induction heating coil is fabricated from a machined or milled flat metal plate, the machining or milling defining a spiral form of the spiral induction heating coil.

2. The assembly according to claim 1, wherein each spiral induction heating coil of the at least one pair of spiral induction heating coils is provided with a water cooling tube (400) extending in a spiral orientation along the spiral form of the spiral induction heating coil.

3. The assembly according to claim 2, wherein each water cooling tube (400) is brazed to a respective spiral induction heating coil (402).

4. The assembly according to any one of claims 1-3, wherein each induction heating coil has a gap of between 4 mm and 8 mm between adjacent turns of induction heating coil.

5. The assembly according to any one of claims 1-3, wherein each induction heating coil has an outside diameter of 63.5 cm (25 inches).

6. The assembly according to any one of claims 1-3, wherein each induction heating coil has an inside diameter of 7.62 cm (3 inches).

7. The assembly according to any one of claims 1-3 wherein the support frame is made from a G-10 glass material.

8. The assembly according to any one of claims 1-3, wherein each induction heating coil is provided with one or more boltheads (401, 520) arranged to provide means for mounting the induction heating coil on the support frame.

9. The assembly according to claim 8, wherein the means for mounting the induction heating coil is adjustable for adjusting a space between the at least one pair of induction heating coils.

10. The assembly according to any one of claims 1-3, wherein the support frame is provided with one or more supports (220, 320, 530) for supporting a porous article (240, 340, 510) being heated by the at least one pair of induction heating coils between the respective induction heating coils at a periphery of the porous article.

11. A method of densifying a porous article in an inductive heating apparatus, comprising:
mounting one or more porous articles in one or more corresponding inductive heating assemblies, according to any one of claims 1-10;
immersing the inductive heating assembly having the porous article mounted therein in a reaction chamber in a liquid densification precursor, such that the liquid precursor infiltrates a porosity of the porous article;
providing electrical power to the at least one pair of spiral induction heating coils to cause the porous article to be inductively heated to temperature to cause the liquid precursor to pyrolize and leave a pyrolytic deposition product within the porosity of the porous article, thereby reducing the porosity of the porous article.

12. The method according to claim 11, wherein the porous article has an initial bulk density before densification between 0.2 to 0.5 g/cm³.

13. The method according to claim 11, wherein the porous article has a final bulk density after densification between 1.50 and 1.90 g/cm³ ± 0.04 g/cm³.

14. The method according to any one of claims 11-13, further comprising rotating the porous article about an axis perpendicular to the at least one pair of spiral induction heating coils.

15. The method according to any one of claims 11-13, wherein the liquid precursor is chosen from the group consisting of: cyclopentane, cyclohexene, 1-hexene, gasoline, toluene, methylcyclohexane, n-hexane, kerosene, hydrodesulfurized kerosene, and benzene, and combinations thereof.

16. The method according to any one of claims 11-13, wherein the porous article is inductively heated to a temperature of between about 900°C and about 1500°C.

17. The method according to any one of claims 11-13, wherein the porous article is round, and has a diameter no larger than a diameter of the pair of induction heating coils.

18. The method according to any one of claims 11-13, wherein a plurality of heating assemblies is provided.

19. The method according to any one of claims 11-13, wherein the electrical power supplies of the plurality of heating assemblies are connected to a common electrical bus.

20. The method according to any one of claims 11-13, further comprising a heat treatment step after the porous article is densified as desired, the heat treatment step comprising:
draining the precursor liquid completely from the reactor chamber,
heating the densified porous article to a temperature between 1600ºC and 2400ºC while applying a pressure between 101.32 kPa and 103.99 kPa (760 Torr and 780 Torr), and
gradually ramping down the applied heating temperature to zero at the end of heat treatment.

21. The method according to any one of claims 11-13, comprising:
setting an initial frequency and power supply to the induction coils, the initial frequency and power supply being effective to accumulate sufficient heat at a geometric center region of the porous article to cause pyrolysis of liquid precursor vapor preferentially in the pores located in the geometric center region of the porous article,
providing electrical power to the induction coils at the initial frequency sufficient to densify the geometric center region of the porous article before substantially densifying other interior regions and an exterior surface of the porous article,
after densifying the geometric center region of the porous article, providing electrical power to the induction coils at one or more frequency settings, the power level and frequency setting being effective to heat the interior of the porous article to cause pyrolysis of the liquid precursor vapor and preferentially deposit a pyrolytic product in the pores located adjacent to the geometric center region,
adjusting the power level supplied to the induction coils at one or more frequency settings, the quantity of power and frequency setting being effective to progressively densify the interior regions of the porous article in a radial direction outwards from the geometric center region of the porous article, and
gradually ramping down the power to zero at the end of the densification process.

## Patentansprüche

1. Induktions-Heizanordnung, umfassend:
einen Tragrahmen (170, 210, 310),
zumindest ein Paar spiralförmiger Induktionsheizspulen (300), die an dem Tragrahmen montiert und zueinander in einer allgemein parallelen Ausrichtung ausgerichtet sind, wobei das Paar von Induktionsheizspulen um einen Spulentrennabstand voneinander beabstandet ist, und
eine elektrische Stromversorgung, die mit dem Paar von Induktionsheizspulen elektrisch verbunden ist,
**dadurch gekennzeichnet, dass** jede spiralförmige Induktionsheizspule aus einer maschinell bearbeiteten oder gefrästen flachen Metallplatte hergestellt ist, wobei das maschinelle Bearbeiten oder Fräsen eine Spiralform der spiralförmigen Induktionsheizspule definiert.

2. Anordnung nach Anspruch 1, wobei jede spiralförmige Induktionsheizspule des zumindest einen Paars von spiralförmigen Induktionsheizspulen mit einem Wasserkühlschlauch (400) versehen ist, der sich in einer spiralförmigen Ausrichtung entlang der Spiralform der spiralförmigen Induktionsheizspule erstreckt.

3. Anordnung nach Anspruch 2, wobei jeder Wasserkühlschlauch (400) an eine jeweilige spiralförmige Induktionsheizspule (402) gelötet ist.

4. Anordnung nach einem der Ansprüche 1 bis 3, wobei jede Induktionsheizspule einen Spalt von 4 mm bis 8 mm zwischen benachbarten Wicklungen der Induktionsheizspule hat.

5. Anordnung nach einem der Ansprüche 1 bis 3, wobei jede Induktionsheizspule einen Außendurchmesser von 63,5 cm (25 Zoll) hat.

6. Anordnung nach einem der Ansprüche 1 bis 3, wobei jede Induktionsheizspule einen Innendurchmesser von 7,62 cm (3 Zoll) hat.

7. Anordnung nach einem der Ansprüche 1 bis 3, wobei der Tragrahmen aus einem G-10 Glasmaterial hergestellt ist.

8. Anordnung nach einem der Ansprüche 1 bis 3, wobei jede Induktionsheizspule mit einem oder mehreren Schraubenköpfen (401, 520) versehen ist, die angeordnet sind, um Mittel zur Montage der Induktionsheizspule an dem Tragrahmen bereitzustellen.

9. Anordnung nach Anspruch 8, wobei das Mittel zur Montage der Induktionsheizspule zur Einstellung eines Raums zwischen dem zumindest einen Paar von Induktionsheizspulen verstellbar ist.

10. Anordnung nach einem der Ansprüche 1 bis 3, wobei der Tragrahmen mit einem oder mehr Trägern (220, 320, 530) zur Halterung eines porösen Artikels (240, 340, 510) versehen ist, der durch das zumindest eine Paar von Induktionsheizspulen zwischen den jeweiligen Induktionsheizspulen an einem Umfang des Werksstücks erwärmt wird.

11. Verfahren zur Verdichtung eines porösen Artikels in einer Induktionsheizvorrichtung, umfassend:
Anordnen eines oder mehrerer poröser Artikel in einer oder mehreren entsprechenden Induktionsheizanordnungen nach einem der Ansprüche 1 bis 10,
Eintauchen der Induktionsheizanordnung mit dem darin angeordneten porösen Artikel in einer Reaktionskammer in einem flüssigen Verdichtungs-Präkursor, so dass der flüssige Präkursor eine Porosität des porösen Artikels infiltriert,
Zuführen elektrischen Stroms an das zumindest eine Paar von spiralförmigen Induktionsheizspulen, um den porösen Artikel dazu zu bringen, induktiv auf eine Temperatur erhitzt zu werden, um den flüssigen Präkursor dazu zu bringen, sich pyrolytisch zu zersetzen, und ein pyrolytisches Ablagerungsprodukt innerhalb der Porosität des porösen Artikels zu hinterlassen, wodurch die Porosität des porösen Artikels verringert wird.

12. Verfahren nach Anspruch 11, wobei der poröse Artikel vor der Verdichtung ein anfängliches Raumgewicht zwischen 0,2 und 0,5 g/cm³ hat.

13. Verfahren nach Anspruch 11, wobei der poröse Artikel ein finales Raumgewicht nach der Verdichtung zwischen 1,50 und 1,90 g/cm³ +/- 0,04 g/cm³ hat.

14. Verfahren nach einem der Ansprüche 11 bis 13, ferner umfassend das Drehen des porösen Artikels um eine Achse senkrecht zu dem zumindest einen Paar von spiralförmigen Induktionsheizspulen.

15. Verfahren nach einem der Ansprüche 11 bis 13, wobei der flüssige Präkursor ausgewählt ist aus der Gruppe bestehend aus: Cyclopentan, Cyclohexen, 1-Hexen, Benzin, Toluol, Methylcyclohexan, n-Hexan, Kerosin, wasserstoffentschwefeltem Kerosin, und Benzen, und Kombinationen dieser.

16. Verfahren nach einem der Ansprüche 11 bis 13, wobei der poröse Artikel induktiv auf eine Temperatur zwischen etwa 900 °C und etwa 1500 °C erhitzt wird.

17. Verfahren nach einem der Ansprüche 11 bis 13, wobei der poröse Artikel rund ist und einen Durchmesser hat, der nicht größer als ein Durchmesser des Paars von Induktionsheizspulen ist.

18. Verfahren nach einem der Ansprüche 11 bis 13, wobei eine Vielzahl von Heizanordnungen bereitgestellt ist.

19. Verfahren nach einem der Ansprüche 11 bis 13, wobei die elektrischen Stromversorgungen der Vielzahl von Heizanordnungen mit einem gemeinsamen elektrischen Bus verbunden sind.

20. Verfahren nach einem der Ansprüche 11 bis 13, ferner umfassend einen Wärmebehandlungsschritt, nachdem der poröse Artikel wie gewünscht verdichtet wurde, wobei der Wärmebehandlungsschritt umfasst:
Vollständiges Ausleiten der Präkursor-Flüssigkeit aus der Reaktorkammer,
Erhitzen des verdichteten porösen Artikels auf eine Temperatur zwischen 1600 °C und 2400 °C, während ein Druck zwischen 101,32 kPa und 103,99 kPa (760 Torr und 780 Torr) angewandt wird, und
schrittweises Verringern der angewandten Heiztemperatur auf Null am Ende der Wärmebehandlung.

21. Verfahren nach einem der Schritte 11 bis 13, umfassend:
Einstellen einer anfänglichen Frequenz und Stromzufuhr zu den Induktionsspulen, wobei die anfängliche Frequenz und Stromzufuhr wirksam sind, um genügend Hitze in einem Bereich des geometrischen Mittelpunkts des porösen Artikels anzusammeln, um die Pyrolyse eines Dampfes eines Flüssig-Präkursors bevorzugt in den Poren, die sich in dem Bereich des geometrischen Mittelpunkts des Vorformlings befinden, zu bewirken,
Zuführen von elektrischem Strom zu den Induktionsspulen mit der Anfangsfrequenz, die ausreicht, um den Bereich des geometrischen Mittelpunkts des Vorformlings zu verdichten, bevor andere innenliegende Bereiche und eine Außenfläche des porösen Artikels wesentlich verdichtet werden,
nach dem Verdichten des Bereichs des geometrischen Mittelpunkts des porösen Artikels, Zuführen von elektrischem Strom zu den Induktionsspulen mit einer oder mehreren Frequenzeinstellungen, wobei die Strompegel- und Frequenzeinstellung dahingehend wirksam ist, um das Innere des porösen Artikels zu erwärmen, um die Pyrolyse des Dampfs eines Flüssig-Präkursors zu bewirken und bevorzugt ein pyrolytisches Produkt in den Poren abzulagern, die sich neben dem Bereich des geometrischen Mittelpunkts befinden,
Einstellen des Strompegels, der den Induktionsspulen bei einer oder mehreren Frequenzeinstellungen zugeführt wird, wobei die Menge des Stroms und die Frequenzeinstellung dahingehend wirksam sind, die inneren Bereiche des Vorformlings von dem Bereich des geometrischen Mittelpunkts des Vorformlings in einer Radialrichtung nach außen fortschreitend zu verdichten, und
schrittweises Verringern des Stroms auf Null am Ende des Verdichtungsprozesses.

## Revendications

1. Ensemble de chauffage par induction comprenant :
un cadre de support (170, 210, 310) ;
au moins une paire de bobines de chauffage par induction en spirale (300) montées sur le cadre de support et alignées l'une avec l'autre dans une orientation généralement parallèle, les deux bobines de chauffage par induction étant espacées l'une de l'autre d'une distance de séparation de bobines ; et
une alimentation électrique connectée électriquement à la paire de bobines de chauffage par induction ;
**caractérisé en ce que** chaque bobine de chauffage par induction en spirale est fabriquée à partir d'une plaque métallique plate usinée ou fraisée, l'usinage ou le fraisage définissant une forme en spirale de la bobine de chauffage par induction en spirale.

2. Ensemble selon la revendication 1, dans lequel chaque bobine de chauffage par induction en spirale de ladite au moins une paire de bobines de chauffage par induction en spirale est pourvue d'un tube de refroidissement par eau (400) s'étendant dans une orientation en spirale le long de la forme en spirale de la bobine de chauffage par induction en spirale.

3. Ensemble selon la revendication 2, dans lequel chaque tube de refroidissement par eau (400) est brasé à une bobine de chauffage par induction en spirale (402) respective.

4. Ensemble selon l'une quelconque des revendications 1 à 3, dans lequel chaque bobine de chauffage par induction a un espace entre 4 mm et 8 mm entre les tours adjacents de la bobine de chauffage par induction.

5. Ensemble selon l'une quelconque des revendications 1 à 3, dans lequel chaque bobine de chauffage par induction a un diamètre extérieur de 63,5 cm (25 pouces).

6. Ensemble selon l'une quelconque des revendications 1 à 3, dans lequel chaque bobine de chauffage par induction a un diamètre intérieur de 7,62 cm (3 pouces).

7. Ensemble selon l'une quelconque des revendications 1 à 3, dans lequel le cadre de support est réalisé à partir d'un verre G-10.

8. Ensemble selon l'une quelconque des revendications 1 à 3, dans lequel chaque bobine de chauffage par induction est pourvue d'une ou de plusieurs têtes de boulon (401, 520) agencées pour fournir des moyens pour monter la bobine de chauffage par induction sur le cadre de support.

9. Ensemble selon la revendication 8, dans lequel les moyens pour monter la bobine de chauffage par induction peuvent être ajustés pour ajuster un espace entre lesdites au moins deux bobines de chauffage par induction.

10. Ensemble selon l'une quelconque des revendications 1 à 3, dans lequel le cadre de support est pourvu d'un ou de plusieurs supports (220, 320, 530) pour supporter un article poreux (240, 340, 510) chauffé par ladite au moins une paire de bobines de chauffage par induction entre les bobines de chauffage par induction respectives au niveau d'une périphérie de l'article poreux.

11. Procédé de densification d'un article poreux dans un appareil de chauffage par induction, comprenant :
le montage d'un ou de plusieurs articles poreux dans un ou plusieurs ensembles de chauffage par induction correspondants, selon l'une quelconque des revendications 1 à 10 ;
l'immersion de l'ensemble de chauffage par induction dans lequel l'article poreux est monté dans une chambre de réaction dans un précurseur de densification liquide, de sorte que le précurseur liquide s'infiltre dans une porosité de l'article poreux ;
la fourniture d'une puissance électrique à ladite au moins une paire de bobines de chauffage par induction en spirale pour provoquer le chauffage par induction de l'article poreux à une température pour amener le précurseur liquide à pyroliser et à laisser un produit de dépôt pyrolytique dans la porosité de l'article poreux, réduisant de ce fait la porosité de l'article poreux.

12. Procédé selon la revendication 11, dans lequel l'article poreux a une densité apparente initiale avant densification entre 0,2 et 0,5 g/cm³.

13. Procédé selon la revendication 11, dans lequel l'article poreux a une densité apparente finale après densification entre 1,50 et 1,90 g/cm³ ± 0,04 g/cm³.

14. Procédé selon l'une quelconque des revendications 11 à 13, comprenant en outre la rotation de l'article poreux autour d'un axe perpendiculaire à ladite au moins une paire de bobines de chauffage par induction en spirale.

15. Procédé selon l'une quelconque des revendications 11 à 13, dans lequel le précurseur liquide est choisi dans le groupe consistant en : le cyclopentane, le cyclohexène, le 1-hexène, l'essence, le toluène, le méthylcyclohexane, le n-hexane, le kérosène, le kérosène hydrodésulfurisé et le benzène, et des combinaisons de ceux-ci.

16. Procédé selon l'une quelconque des revendications 11 à 13, dans lequel l'article poreux est chauffé par induction à une température entre environ 900 °C et environ 1 500 °C.

17. Procédé selon l'une quelconque des revendications 11 à 13, dans lequel l'article poreux est rond, et a un diamètre qui n'est pas supérieur à un diamètre de la paire de bobines de chauffage par induction.

18. Procédé selon l'une quelconque des revendications 11 à 13, dans lequel une pluralité d'ensembles de chauffage sont prévus.

19. Procédé selon l'une quelconque des revendications 11 à 13, dans lequel les alimentations électriques de la pluralité d'ensembles de chauffage sont connectées à un bus électrique commun.

20. Procédé selon l'une quelconque des revendications 11 à 13, comprenant en outre une étape de traitement thermique après que l'article poreux a été densifié selon les souhaits, l'étape de traitement thermique comprenant :
l'évacuation complète du précurseur liquide de la chambre de réaction,
le chauffage de l'article poreux densifié à une température entre 1 600 °C et 2 400 °C tout en appliquant une pression entre 101,32 kPa et 103,99 kPa (760 Torrs et 780 Torrs), et
la diminution linéaire graduelle de la température de chauffage appliquée jusqu'à zéro à la fin du traitement thermique.

21. Procédé selon l'une quelconque des revendications 11 à 13, comprenant :
l'établissement d'une fréquence initiale et d'une alimentation des bobines d'induction, la fréquence initiale et l'alimentation étant efficaces pour accumuler une chaleur suffisante au niveau d'une région centrale géométrique de l'article poreux pour provoquer la pyrolyse de la vapeur de précurseur liquide de préférence dans les pores situés dans la région centrale géométrique de l'article poreux,
la fourniture d'une puissance électrique aux bobines d'induction à la fréquence initiale suffisante pour densifier la région centrale géométrique de l'article poreux avant de densifier sensiblement les autres régions intérieures et une surface extérieure de l'article poreux,
après la densification de la région centrale géométrique de l'article poreux, la fourniture d'une puissance électrique aux bobines d'induction à un ou plusieurs réglages de fréquence, le réglage du niveau de puissance et de la fréquence étant efficace pour chauffer l'intérieur de l'article poreux pour provoquer la pyrolyse de la vapeur de précurseur liquide et de préférence déposer un produit pyrolytique dans les pores situés adjacents à la région centrale géométrique,
l'ajustement du niveau de puissance fourni aux bobines d'induction à un ou plusieurs réglages de fréquence, le réglage de la quantité de puissance et de la fréquence étant efficace pour densifier progressivement les régions intérieures de l'article poreux dans une direction radiale vers l'extérieur à partir de la région centrale géométrique de l'article poreux, et
la diminution linéaire graduelle de la puissance jusqu'à zéro à la fin du processus de densification.
